# EUROPÄISCHE PATENTSCHRIFT

(11) **EP 0 342 498 B1**
(45) Veröffentlichungstag und Bekanntmachung des Hinweises auf die Patenterteilung: **22.12.1993**
(21) Anmeldenummer: 89108375.0
(22) Anmeldetag: 10.05.1989
(51) Int. Cl.: G03F 7/004, G03F 7/039

(54) **Positiv und negativ arbeitende strahlungsempfindliche Gemische sowie Verfahren zur Herstellung von Reliefmustern**
Light-sensitive negative or positive composition, and process for the formation of relief patterns
Composition photosensible positives ou négatives et procédé pour la fabrication d'images en relief

(30) Priorität: 19.05.1988 DE 3817012
(43) Veröffentlichungstag der Anmeldung: 23.11.1989
(73) Patentinhaber: BASF Aktiengesellschaft, 67063 Ludwigshafen (DE)
(72) Erfinder: Schwalm, Reinhold, Dr., D-6706 Wachenheim (DE); Binder, Horst, D-6840 Lampertheim (DE)

(56) Entgegenhaltungen:
- EP-A- 0 297 443
- DE-A- 3 628 046
- JP-A-62 038 450
- JOURNAL OF IMAGING TECHNOLOGY. vol. 11, no. 4, August 1985, SPRINGFIELD US Seiten 146 - 157; PAPPAS S. PETER: "Photogeneration of Acid: A Review of Basic Principles for Resist Imaging Applications".
- Research Disclosure, Jan. 1987, S. 24, Nr. 27331.

## Beschreibung

Die Erfindung betrifft positiv und negativ arbeitende strahlungsempfindliche Gemische, die ein polymeres Bindemittel und eine Verbindung, die mindestens eine durch Säure spaltbare Bindung enthält und unter Einwirkung von Strahlung eine starke Säure bildet, wobei die Löslichkeit der Verbindung in einem alkalischen Lösungsmittel durch die Einwirkung der Säure erhöht wird, enthalten. Diese Gemische sind sensitiv gegenüber UV-, Elektronen- und Röntgenstrahlen und eignen sich besonders als Resistmaterialien.

Positiv arbeitende strahlungsempfindliche Gemische sind bekannt. Kommerziell werden besonders positiv arbeitende Resistmaterialien, die o-Chinondiazide in wäßrig-alkalisch löslichen Bindemitteln, z.B. Novolaken oder Poly-(p-vinylphenol)en, enthalten, eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärfotoreaktion eine Spezies erzeugen, die dann unabhängig von der Strahlung eine katalytische Sekundärreaktion auslösen, sind ebenfalls bereits bekannt. So werden in US-A 3,915,706 beispielsweise Photoinitiatoren beschrieben, die eine starke Säure erzeugen, die dann in einer Sekundärreaktion säurelabile Gruppen, wie Polyaldehydgruppierungen spalten.

Weiterhin sind strahlungsempfindliche Gemische auf Basis von säurespaltbaren Verbindungen bekannt, die als Bindemittel ein in wäßrig-alkalischen Lösungen lösliches Polymer, sowie eine Verbindung, die photochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (DE-A- 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen Überblick über die Anwendung von Oniumsalzen in Resistmaterialien gibt Crivello in 'Org. Coatings and Appl. Polym. Sci., 48, Seiten 65-69 (1985). Nachteilig bei diesen Photoinitiatoren ist, daß sie durch die Einwirkung der Strahlung nicht so verändert werden, daß außer der erzeugten Säure keine weiteren Photoprodukte entstehen, die eine Erhöhung der Löslichkeit im alkalischen Entwickler ergeben. Weiterhin benötigen diese Gemische zwingend drei Komponenten und arbeiten nur positiv.

Strahlungsempfindliche Gemische von Polymeren mit säurelabilen t-Butylcarbonat oder t-Butylester-Seitengruppen und photochemischen Säurespendern sind z.B. aus US-A- 4,491,628 und FR-A- 2,570,844 bekannt. Diese Gemische arbeiten sowohl positiv als auch negativ, indem man entweder mit einem polaren oder einem unpolaren Lösungsmittel entwickelt.

Bekannt sind auch lichtempfindliche Aufzeichnungsmaterialien, welche Tetrahydropyranylether, ein Säure liefernder Photoinitiator und gegebenenfalls ein polymers Bindemittel enthalten (DE-A- 2 306 248). Diese Gemische arbeiten ebenfalls nur positiv.

Weiterhin sind positiv und negativ arbeitende Gemische, bestehend aus phenolischen Harzen, speziell Novolaken, und Oniumsalzen bekannt. Diese Gemische arbeiten positiv, wenn man sie bestrahlt und mit alkalischen Entwicklern entwickelt. Sie arbeiten negativ, wenn man die Gemische erhitzt und damit die bestrahlten Bereiche so umwandelt, daß sie unlöslich in alkalischen Entwicklern werden, und anschließend nochmals vollflächig belichtet und damit die vorher unbelichteten Bereiche so umwandelt, daß sie alkalilöslich werden und danach mit alkalischen Entwicklern herausgelöst werden können (EP-A- 146 411). Die positiv arbeitenden Gemische haben den Nachteil, daß sie relativ unempfindlich sind, die negativ arbeitenden Gemische benötigen eine große Zahl von Verfahrensschritten.

In DE-A- 3 721 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt. Diese Gemische arbeiten positiv.

Aufgabe der vorliegenden Erfindung ist es, hochreaktive strahlungsempfindliche Systeme für die Herstellung von Reliefstrukturen zur Verfügung zu stellen, die sich mit wäßrig-alkalischen Lösungen entwickeln lassen und die sowohl positiv als auch negativ arbeiten.

Überraschenderweise wurde gefunden, daß sich strahlungsempfindliche Gemische mit hoher Empfindlichkeit herstellen lassen, die sowohl positiv als auch negativ mit Alkalien entwickelt werden können, ohne daß zusätzliche Verfahrensschritte notwendig sind.

Gegenstand der vorliegenden Erfindung ist ein strahlungsempfindliches Gemisch, enthaltend
- (a): ein polymeres Bindemittel und
- (b): eine organische Verbindung, deren Löslichkeit in einem wäßrigalkalischen Entwickler durch Einwirkung von Säure erhöht wird und die mindestens eine durch Säure spaltbare Gruppierung enthält, sowie eine zusätzliche Gruppierung, die unter Einwirkung von Strahlung eine starke Säure bildet, das dadurch gekennzeichnet ist, daß als polymeres Bindemittel (a) ein Umsetzungsprodukt aus einem phenolische Hydroxylgruppen enthaltenden Polymeren mit Dihydropyran oder ein durch Polymerisation oder Polykondensation von Umsetzungsprodukten phenolische Hydroxylgruppen enthaltender monomerer Verbindungen mit Dihydropyran erhaltenes Polymerisat bzw. Polykondensat eingesetzt wird.

Im polymeren Bindemittel (a) können vorzugsweise 10 bis 100% der im Polymeren ursprünglich vorhandenen phenolischen Hydroxylgruppen mit Dihydropyran umgesetzt sein, wobei als polymere Bindemittel (a) sowohl Umsetzungsprodukte aus Novolak auf Basis von p-Kresol/Formaldehyd mit Dihydropyran, als auch Umsetzungsprodukte aus Poly-(p-hydroxistyrol), Poly-(p-hydroxi-α-methylstyrol) oder einem Copolymeren von p-Hydroxistyrol und p-Hydroxi-α-methylstyrol mit Dihvdropyran eingesetzt werden können.

Als organische Verbindung (b) bevorzugt sind Sulfoniumsalze der allgemeinen Formel (I) 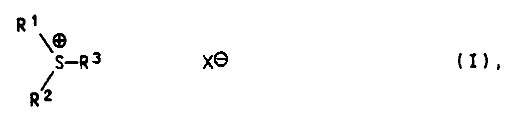
worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet.

Gegenstand der vorliegenden Erfindung ist auch ein Verfahren zur Herstellung von Reliefmustern und Reliefbildern, wobei man ein strahlungsempfindliches Gemisch gemäß der vorliegenden Erfindung als Beschichtungsmaterial einsetzt.

Positive Resistmuster erhält man mit den erfindungsgemäßen strahlungsempfindlichen Gemischen, wenn man nach dem Belichten bei Temperaturen zwischen 60°C und 90°C ausheizt und anschließend mit alkalischen Entwicklern entwickelt. Negative Resistmuster erhält man nach dem gleichen Verfahren, jedoch wird nach der Belichtung bei Temperaturen zwischen 12O°C und 200°C ausgeheizt.

Zu den Aufbaukomponenten des erfindungsgemäßen strahlungsempfindlichen Gemisches ist im einzelnen folgendes auszuführen.

Als Ausgangsprodukte zur Herstellung des erfindungsgemäß einzusetzenden polymeren Bindemittels (a) kommen bevorzugt phenolische Harze, wie z.B. Novolake, insbesondere solche auf Basis p-Kresol/Formaldehyd, Poly-(p-hydroxistyrole), Poly-(p-hydroxi-α-methylstyrole) oder Copolymere von p-Hydroxistyrol bzw. p-Hydroxi-α-methylstyrol, in Frage. Diese werden ganz oder teilweise mit Dihydropyran ungesetzt, so daß sie beispielsweise im Falle des Umsetzungsproduktes mit Dihydropyran Gruppierungen der allgemeinen Formel (II) 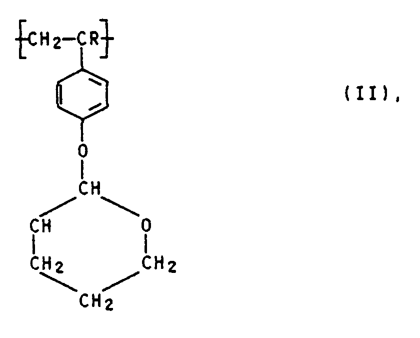
worin
R für H oder Alkyl
mit 1 bis 3 Kohlenstoffatomen steht,
enthalten.

Als Novolake (Ausgangsmaterial) kommen solche in Frage, wie sie z.B. in "Novolak Resins Used in Positiv Resist Systems" von T. Pampalone in "Solid State Technology, June 1984, Seite 115 - 120, beschrieben sind. Für spezielle Anwendungen, z.B. für Belichtung im kurzwelligen UV-Gebiet kommen bevorzugt Novolake aus p-Kresol und Formaldehyd in Frage. Diese

Novolake können dann beispielsweise mit Dihydropyran in Gegenwart von katalytischen Mengen Salzsäure in beispielsweise Ethylacetat so umgesetzt werden, daß die phenolischen OH-Gruppen ganz oder teilweise verethert werden.

Phenolische Haize auf Basis von Hydroxystyrolen lassen sich nach gängigen Methoden radikalisch oder ionisch aus mehreren ungesättigten Monomeren copolymerisieren. Ungesättigte Komponenten, welche bevorzugt copolymerisiert werden können, sind beispielsweise substituierte und unsubstituierte Hydroxistyrole, wie p-Hydroxistyrol, m-Hydroxistyrol, p-(tetrahydropyranyi-oxi-)styrol und p-Hydroxi-α-methyl-styrol.

Diese erfindungsgemäßen Polymeren auf Basis von Hydroxistyrolen können ebenfalls durch polymeranaloge Umsetzung von z.B. Poly-(p-Hydroxistyrol) mit den entsprechenden stöchiometrischen Mengen oder geringeren als stöchiometrischen Mengen von z.B. Dihydropyran umgesetzt werden.

Besonders bevorzugt ist die Umsetzung der phenolische Hydroxylgruppen enthaltenden Kondensate oder Polymerisate mit Dihydropyran.

Erfindungsgemäß bevorzugt sind 10 bis 100, insbesondere 15 bis 30 % der phenolischen Hydroxylgruppen des polymeren Bindemittels mit Dihydropyran verethert.

Die Zusammensetzung der Copolymeren (a) läßt sich durch H-NMR-Spektroskopie bestimmen.

Komponente (a) ist im erfindungsgemäßen strahlungsempfindlichen Gemisch in einer Menge von 70 bis 98, vorzugsweise 80 bis 95 % enthalten.

Als organische Verbindungen (b) sind solche bevorzugt, welche mindestens eine Sulfoniumsalzgruppierung und mindestens eine t-Butylcarbonatgruppierung oder mindestens eine Silylethergruppierung enthalten. Es können jedoch auch andere Verbindungen verwandt werden, welche unter Bestrahlung eine starke Säure bilden und im gleichen Molekül eine säurespaltbare Bindung enthalten.

Bevorzugte derartige organische Verbindungen (b) sind solche der allgemeinen Formel (I) 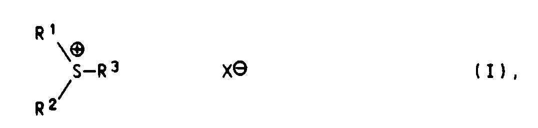
worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure spaltbare Gruppierungen, verknüpft sein kann und X^{⊖} ein nichtnucleophiles Gegenion bedeutet, wie z.B. Dimethyl-4-t-butoxicarbonyloxiphenyl-sulfoniumsalz mit Hexafluoroarsenat, Hexafluoroantimonat, Hexafluorophosphat und/oder Hexafluoroborat als Gegenion, Phenyl-bis-(4-t-butoxicarbonyloxiphenyl-)sulfoniumsalz mit den genannten Gegenionen, Tris-(4-t-butoxicarbonyloxiphenyl-)sulfoniumsalz mit den genannten Gegenionen, 4-Hydroxiphenyl-bis-(4-t-butoxicarbonyloxiphenyl-)sulfoniumsalz mit den genannten Gegenionen oder 1-Naphthyl-4-trimethylsilyloxitetramethylen-sulfoniumsalz mit den genannten Gegenionen.

Besonders bevorzugte derartige organische Verbindungen (b) sind solche der allgemeinen Formel (III) 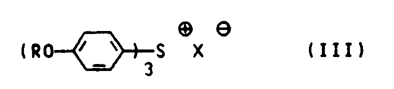
worin R = H, t-butoxicarbonyl- und/oder Trialkylsilyl- sein kann, mit der Maßgabe, daß mindestens einer der Reste R ≠ H ist.

Die Herstellung der oben genannten Sulfoniumsalze ist beispielsweise in DE-A-37 21 741 und DE-A-37 21 740 beschrieben.

Die organische Verbindung (b) ist im erfindungsgemäßen Gemisch im allgemeinen in einer Menge von 2 bis 30, vorzugsweise 5 bis 20 Gewichtsprozent, bezogen auf die Gesamtmenge (= Summe) von (a) und (b) enthalten.

Die erfindungsgemäßen strahlungsempfindlichen Gemische sind sensitiv gegenüber Röntgen-, Elektronen- und UV-Strahlung. Gegebenenfalls können Sensibilisatoren in geringen Mengen zugesetzt werden, wie beispielsweise Pyren und Perylen, um die Verbindungen im längerwelligen UV bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Ouecksilberlampen nutzt man die 254 nm Linie oder man verwendet Excimer-Laser, die bei 248 nm (KrF) emittieren. Strahlungsempfindliche Aufzeichnungsmaterialien sollten deshalb in diesem Bereich möglichst niedrige optische Dichten aufweisen. Für diese Anwendungen haben sich die erfindungsgemäßen polymeren Bindemittel auf Basis von Novolaken als weniger geeignet herausgestellt, so daß für diese speziellen Anwendungen bevorzugt die polymeren Bindemittel auf Basis von Hvdroxistyrolen eingesetzt werden.

Bei dem erfindungsgemäßen Verfahren zur Herstellung von positiven Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche nach einem thermischen Ausheizschritt bei Temperaturen zwischen 60°C und 90°C in wäßrig-alkalischen Lösungsmitteln zunimmt und diese Bereiche selektiv mit dem alkalischen Entwickler entfernt werden können.

Bei dem erfindungsgemäßen Verfahren zur Herstellung von negativen Reliefmustern wird die strahlungsempfindliche Aufzeichnungsschicht bildmäßig in solcher Dosis bestrahlt, daß die belichteten Bereiche nach einem thermischen Ausheizschritt bei Temperaturen zwischen 120°C und 200°C in einem wäßrig-alkalischen Entwickler nicht mehr löslich sind. Die unbelichteten Bereiche lassen sich dagegen nach dieser Behandlung vollständig mit dem wäßrig alkalischen Entwickler entfernen.

Vorzugsweise wird z.B. das polymere Bindemittel (a), beispielsweise Poly-p-hydroxystyrol, in welchem die phenolische Monomerkomponente zwischen 10 und 100 % mit Dihydropyran umgesetzt ist, und zwischen 5 und 20 Gew.%, besonders bevorzugt zwischen 5 und 15 Gew.% einer Verbindung des Typs (b), bezogen auf das Gesamtgewicht der Verbindungen (a) und (b), in einem geeigneten inerten Lösungsmittel, beispielsweise in Methylglykolacetat oder Methyl-propylenglykol-acetat gelöst, so daß der Feststoffgehalt zwischen 10 und 30 Gew.% beträgt.

Die Lösung kann durch ein Filter mit einem Porendurchmesser von 0,2 µm filtriert werden. Durch Aufschleudern der Resistlösung bei Umdrehungszahlen zwischen 1000 und 10 000 U/min wird ein Resistfilm (Dicke ca. 1 µm) auf einem Wafer (z.B. einem Siliziumwafer, der an der Oberfläche oxidiert ist) erzeugt. Der Wafer wird dann zwischen 1 und 5 Minuten bei 90°C bzw. 80°C ausgeheizt. Die so erhaltenen Filme werden durch eine chrombeschichtete strukturierte Quarzmaske mit UV-Licht einer Quecksilberlampe, mit Excimer-Laserlicht, Elektronen- oder Röntgenstrahlen bestrahlt. Die bestrahlten Filme werden entweder zwischen 5 Sekunden und 2 Minuten bei Temperaturen zwischen 60°C und 80°C oder zwischen 10 Sekunden und 2 Minuten bei Temperaturen zwischen 120°C und 200°C ausgeheizt. Die so behandelten Filme werden hierauf mit alkalischen oder alkoholischen Entwicklern entwickelt, wobei sich die belichteten Bereiche selektiv ablösen, wenn die niedrigeren Ausheiztemperaturen zwischen 60°C und 80°C gewählt werden, während sich die unbelichteten Bereiche selektiv lösen, wenn die Ausheiztemperaturen größer oder gleich 120°C angewandt werden.

Als Entwickler eignen sich die üblichen im Handel erhältlichen, beispielsweise solche auf Basis von Natriumhydroxid, Natrium- oder Kaliumsilikaten oder Tetraalkylammonium-hydroxiden.

Die erfindungsgemäßen strahlungsempfindlichen Gemische zeichnen sich insbesondere durch hohe Empfindlichkeit, gute Auflösung und leichte Verarbeitbarkeit aus und eignen sich daher besonders vorteilhaft für die Lithographie im kurzwelligen UV-Bereich.

Die in den Beispielen genannten Teile und Prozente sind, soweit nicht anders angegeben, Gewichtsteile und Gewichtsprozente.

### Synthese der Polymeren

2 Teile Poly-(p-hydroxystyrol) vom Molekulargewicht M̅_{w} (Lichtstreuung) = 62 000 g/mol werden in 20 Teilen Ethylacetat gelöst. Dazu gibt man 10 Teile Dihydropyran und 0,5 Teile konzentrierte Salzsäure. Man läßt die Mischung 62 Stunden bei Raumtemperatur reagieren und fällt anschließend in Ligroin. Das Polymere wird mit verdünnter Natriumhydrogencarbonat-Lösung gewaschen und bei 50°C im Vakuum getrocknet. Die IR- und H-NMR-spektroskopische Analyse zeigen, daß die phenolische OH-Funktion vollständig verethert ist und daß ein Tetrahydropyranylether von Poly-(p-hydroxistyrol) entstanden ist.

Analog werden Polymere mit teilweise veretherten phenolischen Gruppen hergestellt, indem die entsprechenden stöchiometrischen Mengen Dihydropyran zugegeben werden.

### Beispiel 1

### Herstellung der Resistlösung

Eine Photoresistlösung wird aus 10 Teilen Tris-(4-t-butoxicarbonyloxiphenyl)sulfoniumhexafluoroarsenat, 90 Teilen eines Copolymeren mit (p-Hydroxystyrol)- und (p-2-Tetrahydropyranyl-oxistyrol)-einheiten (75:25) (Molekulargewicht M̅ₙ: 22 000 g/mol (GPC)) und 400 Teilen Methylpropylenglykolacetat hergestellt. Die Lösung wird anschließend durch ein Filter mit einem Porendurchmesser von 0,2 µm filtriert.

### Lithographische Untersuchungen

### a) Positivverfahren

Die Resistlösung wird auf einen mit einem SiO₂-Film bedeckten Siliziumwafer mit einer Umdrehungszahl von 7900 U/min in einer Schichtdicke von 1,07 µm aufgeschleudert. Der Wafer wird eine Minute bei 90°C getrocknet und anschließend mit einer bildmäßig strukturierten Testmaske im Kontaktverfahren 15 Sekunden mit Excimer-Laserlicht der Wellenlänge 248 nm belichtet. Danach wird 60 Sekunden bei 70°C ausgeheizt und mit einem alkalischen Entwickler (pH-Wert 12,3) 60 Sekunden entwickelt. Die belichteten Bereiche sind vollständig abgetragen und die Resistmuster sind ein positives Abbild der Maske. Die Empfindlichkeit beträgt 100 mJ/cm².

### b) Negativverfahren

Die Resistlösung wird wie in a) aufgeschleudert (Schichtdicke 1.005 µm) und 1 Minute bei 90°C ausgeheizt. Anschließend wird mit der Testmaske im Kontaktverfahren 20 Sekunden mit Excimer-Laserlicht der Wellenlänge 248 nm belichtet und danach 1 Minute bei 120°C ausgeheizt. Nach einer Entwicklungszeit von 90 Sekunden mit dem alkalischen Entwickler (pH 12,3) sind die unbelichteten Bereiche vollständig abgetragen, während in den belichteten Bereichen eine Schichtdicke von ca. 1 µm verbleibt. Die Sensitivität beträgt 70 mJ/cm². Es entstehen negative Muster der Maske.

### Beispiel 2

Eine Photoresistlösung wird aus 10 Teilen Tris-(4-t-butoxicarbonyloxi-phenyl-)sulfoniumhexafluorophosphat, 90 Teilen eines Copolymeren mit p-Hydroxystyrol- und p-2-Tetrahydropyranyl-oxistyrol-einheiten (90:10) (Molekulargewicht M̅ₙ 16 500 g/mol (GPC)), und 400 Teilen Methylpropylenglykolacetat hergestellt. Die Lösung wird anschließend durch ein Filter mit einem Porendurchmesser von 0,2 µm filtriert.

Die Resistlösung wird auf einen mit einem SiO₂-Film versehenen Siliziumwafer mit einer Umdrehungszahl von 9820 U/min in einer Schichtdicke von 0,99 µm aufgeschleudert. Der Wafer wird eine Minute bei 90°C getrocknet und anschließend mit einer bildmäßig strukturierten Testmaske im Kontaktverfahren 15 Sekunden mit Exicimer-Laserlicht der Wellenlänge 248 nm belichtet. Danach wird 60 Sekunden bei 80°C ausgeheizt und mit einem Entwickler vom pH-Wert 12.3 60 Sekunden entwickelt. Die belichteten Bereiche sind vollständig abgetragen und die Resistmuster sind ein positives Abbild der Maske. Die Empfindlichkeit beträgt 250 mJ/cm².

Heizt man dieses Gemisch nach der Belichtung bei 120°C aus, so entstehen ebenfalls negative Strukturen. Die Empfindlichkeit beträgt 100 mJ/cm².

## Patentansprüche

1. Strahlungsempfindliches Gemisch, enthaltend
(a) ein polymeres Bindemittel und
(b) eine organische Verbindung, deren Löslichkeit in einem wäßrig-alkalischen Entwickler durch Einwirkung von Säure erhöht wird und die mindestens eine durch Säure spaltbare Gruppierung enthält, sowie eine zusätzliche Gruppierung, die unter Einwirkung von Strahlung eine starke Säure bildet,
dadurch gekennzeichnet, daß als polymeres Bindemittel (a) ein Umsetzungsprodukt aus einem phenolische Hydroxylgruppen enthaltenden Polymeren mit Dihydropyran oder ein durch
Polymerisation oder Polykondensation von Umsetzungsprodukten phenolische Hydroxylgruppen enthaltender monomerer Verbindungen mit Dihydropyran erhaltenes Polymerisat bzw.
Polykondensat eingesetzt wird.

2. Strahlungsempfindliches Gemisch nach Anspruch 1, dadurch gekennzeichnet, daß im polymeren Bindemittel (a) 10 bis 100 % der im Polymeren ursprünglich vorhandenen phenolischen Hydroxylgruppen mit Dihydropyran umgesetzt sind.

3. Strahlungsempfindliches Gemisch nach einem der vorhergehenden Ansprüche, dadurch gekennzeichnet, daß als polymeres Bindemittel (a) ein Umsetzungsprodukt aus einem Novolak auf Basis von p-Kresol/Formaldehyd mit Dihydropyran
eingesetzt wird.

4. Strahlungsempfindliches Gemisch nach Anspruch 1 oder 2, dadurch gekennzeichnet, daß als polymeres Bindemittel (a) ein Umsetzungsprodukt aus Poly- (p-hydroxistyrol), Poly(p-hydroxi-α-methylstyrol) oder einem Copolymeren von p-Hydroxistyrol und p-Hydroxi-α-methylstyrol mit Dihydropyran
eingesetzt wird.

5. Strahlungsempfindliches Gemisch nach einem der vorhergehenden Ansprüche, dadurch gekennzeichnet, daß als organische Verbindung (b) ein Sulfoniumsalz der allgemeinen Formel (I) eingesetzt wird 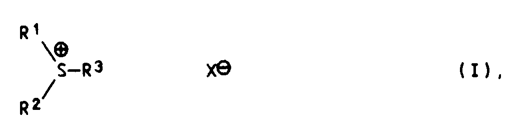 worin R¹, R² und R³ untereinander gleich oder verschieden sind und für aliphatische und/oder aromatische Reste, die gegebenenfalls Heteroatome enthalten, stehen oder zwei der Reste R¹ bis R³ miteinander zu einem Ring verknüpft sind, mit der Maßgabe, daß mindestens einer der Reste R¹ bis R³ mindestens eine durch Säure spaltbare Gruppierung enthält, wobei einer der Reste R¹ bis R³ mit einem oder mehreren weiteren Sulfoniumsalzresten, gegebenenfalls über durch Säure abspaltbare Gruppierungen, verknüpft sein kann, und X^{⊖} ein nichtnukleophiles Gegenion bedeutet.

6. Verfahren zur Herstellung von Reliefmustern und Reliefbildern, dadurch gekennzeichnet, daß man ein strahlungsempfindliches Gemisch gemäß einem der vorhergehenden Ansprüche einsetzt.

7. Verfahren zur Herstellung von positiven Reliefmustern nach Anspruch 6, dadurch gekennzeichnet, daß nach der Belichtung des strahlungsempfindlichen Gemisches auf Temperaturen zwischen 60 und 90°C erhitzt und anschließend mit alkalischen Entwicklern entwickelt wird.

8. Verfahren zur Herstellung von negativen Reliefmustern nach Anspruch 6, dadurch gekennzeichnet, daß nach der Belichtung des strahlungsempfindlichen Gemisches auf Temperaturen zwischen 120° und 200°C erhitzt und anschließend mit alkalischen Entwicklern entwickelt wird.

## Claims

1. A radiation sensitive mixture comprising
(a) a polymeric binder and
(b) an organic compound whose solubility in an aqueous alkaline developer is increased by the action of acid and which contains at least one acid cleavable group and additionally a group which forms a strong acid on irradiation,
wherein the polymeric binder (a) is a reaction product of a polymer that contains phenolic hydroxyl groups with dihydropyran or is a polymer or polycondensate obtained by polymerization or polycondensation of reaction products of monomeric compounds that contain phenolic hydroxyl groups with dihydropyran.

2. A radiation sensitive mixture as claimed in claim 1, wherein in the polymeric binder (a) from 10 to 100% of the phenolic hydroxyl groups originally present in the polymer have been reacted with dihydropyran.

3. A radiation sensitive mixture as claimed in either of the preceding claims, wherein the polymeric binder (a) is a reaction product of a novolak based on p-cresol/formaldehyde with dihydropyran.

4. A radiation sensitive mixture as claimed in claim 1 or 2, wherein the polymeric binder (a) is a reaction product of poly(p-hydroxystyrene), poly(p-hydroxy-α-methylstyrene) or a copolymer of p-hydroxystyrene and p-hydroxy-α-methylstyrene with dihydropyran.

5. A radiation sensitive mixture as claimed in any of the preceding claims, wherein the organic compound (b) is a sulfonium salt of the general formula (I) 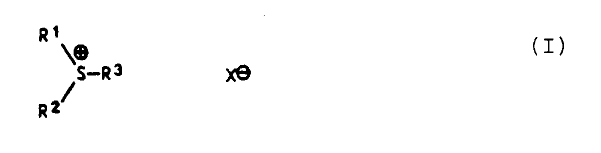 where R¹, R² and R³ are identical to or different from one another and each is singly acyclyl or aryl which each may contain heteroatoms, or two of R¹ to R³ together form a ring, with the proviso that at least one of R¹ to R³ contains one or more acid cleavable groups, one of R¹ to R³ can be linked to one or more further sulfonium salt residues directly or via acid cleavable groups, and X^{⊖} is a nonnucleophilic counterion.

6. A process for producing relief patterns and relief images, which comprises using a radiation sensitive mixture as claimed in any of the preceding claims.

7. A process for producing positive relief patterns as claimed in claim 6, wherein exposure of the radiation sensitive mixture is followed by heating at from 60 to 90°C and subsequent development with an alkaline developer.

8. A process for producing negative relief patterns as claimed in claim 6, wherein exposure of the relief sensitive mixture is followed by heating at from 120 to 200°C and subsequent development with an alkaline developer.

## Revendications

1. Mélange sensible aux radiations, contenant
(a) un liant polymère et
(b) un composé organique dont la solubilité dans un révélateur alcalin aqueux est augmentée sous l'action d'un acide et qui contient au moins un groupement dissociable par un acide, ainsi qu'au moins un groupement additionnel qui, sous l'action de radiations, forme un acide fort,
caractérisé par le fait que l'on utilise, comme liant polymère (a), un produit de réaction d'un polymère contenant des groupes hydroxyle phénoliques avec du dinydropyranne ou un polymérisat ou polycondensat obtenu par polymérisation ou polycondensation de produits de réaction de composés monomères contenant des groupes hydroxyle phénoliques avec du dihydropyranne.

2. Mélange sensible aux radiations selon la revendication 1, caractérisé par le fait que dans le liant polymère (a), 10 à 100 % des groupes hydroxyle phénoliques initialement présents dans le polymère ont été mis à réagir avec du dihydropyranne.

3. Mélange sensible aux radiations selon l'une des revendications précédentes, caractérisé par le fait que l'on utilise, comme liant polymère (a), un produit de réaction d'une novolaque à base de p-crésol/formaldéhyde avec du dihydropyranne.

4. Mélange sensible aux radiations selon l'une des revendications 1 ou 2, caractérisé par le fait que l'on utilise, comme liant polymère (a), un produit de réaction de poly-(p-hydroxystyrène), poly(p-hydroxy-α-méthylstyrène) ou d'un copolymère de p-hydroxystyrène et p-hydroxy-α-méthylstyrène avec du dinydropyranne.

5. Mélange sensible aux radiations selon l'une des revendications précédentes, caractérisé par le fait que l'on utilise, comme composé organique (b), un sel de sulfonium de formule générale (I) 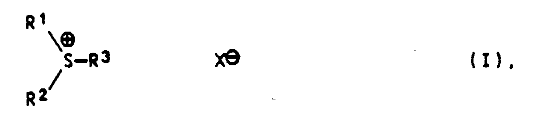 dans laquelle R1, R2 et R3 sont identiques ou différents et sont mis pour les restes aliphatiques et/ou aromatiques contenant éventuellement des hétéro-atomes, ou deux des restes R1 à R3 sont reliés entre eux en formant un cycle, étant entendu qu'au moins un des restes R1 à R3 contient au moins un groupement dissociable par un acide et un des restes R1 à R3 peut être relié avec un ou plusieurs autres restes sel de sulfonium, éventuellement par l'intermédiaire de groupements séparables par un acide, X^{⊖} représentant un on opposé non nucléophile.

6. Procédé de préparation de modèles en relief et images en relief, caractérisé par le fait que l'on utilise un mélange sensible aux radiations selon l'une des revendications précédentes.

7. Procédé de préparation de modèles en reliefs positifs selon la revendication 6, caractérisé par le fait que le mélange sensible aux radiations est chauffé, après l'exposition, à des températures comprises entre 60 et 90°C et est développé ensuite avec des révélateurs alcalins.

8. Procédé de préparation de modèles en relief négatifs selon la revendication 6, caractérisé par le fait que le mélange sensible aux radiations est chauffé, après l'exposition, à des températures comprises entre 120 et 200°C et est développé ensuite avec des révélateurs alcalins.
